# EUROPEAN PATENT APPLICATION

(11) **EP 4 258 248 A1**
(43) Date of publication of application: **11.10.2023**
(21) Application number: 21903273.7
(22) Date of filing: 02.12.2021
(51) Int. Cl.: G09F 9/30, G09F 9/33, B60J 1/00

(54) **TRANSPARENT DISPLAY DEVICE, LAMINATED GLASS, AND METHOD FOR PRODUCING TRANSPARENT DISPLAY DEVICE**

(30) Priority: 07.12.2020 JP 2020202483
(71) Applicant: AGC INC., Chiyoda-ku, Tokyo 1008405 (JP)
(72) Inventor: TAO, Yukihiro, Tokyo 100-8405 (JP); KOGA, Masahide, Tokyo 100-8405 (JP); MITSUI, Yoko, Tokyo 100-8405 (JP)
(74) Representative: Müller-Boré & Partner Patentanwälte PartG mbB
(86) International application number: PCT/JP2021/044180
(87) International publication number: WO 2022/124169

(57) **Abstract**

A transparent display device according to an aspect of the present invention includes: a transparent substrate (10); and light-emitting diode elements (21) to (23) arranged for each pixel on the transparent substrate (10), a rear-face side of the transparent display device being visually recognizable from a viewing side. The light-emitting diode elements (21) to (23) are semiconductor chips with an area of 10,000 µm² or less, and a main surface on the rear-face side in the light-emitting diode elements (21) to (23) is covered by a light-shielding film (60). Light emitted from the LED elements (21) to (23) can be prevented from leaking to the rear-face side.

## Description

### Technical Field

The present invention relates to a transparent display device, a laminated glass, and a manufacturing method of the transparent display device.

### Background Art

Display devices which use a light-emitting diode (LED) element in a pixel are known. Patent Literature 1 discloses, among such display devices, a transparent display device in which a size of an LED element is minute and of which a rear-face side is visually recognizable via the display device.

With transparent display devices, there is a demand to make an image to be displayed to a viewing side not visually recognizable from the rear-face side (an opposite side of the viewing side). In other words, there is a demand to suppress leakage to the rear-face side of light emitted from an LED element.

A transparent display device disclosed in Patent Literature 2 is provided with a light-shielding member which blocks light emitting from a through-hole packaged LED (light emitter) from being transmitted to a rear-face side on which the light emitter is not arranged.

### Citation List

### Patent Literature

Patent Literature 1: Published Japanese Translation of PCT International Publication for Patent Application, No. 2017-521859
Patent Literature 2: Japanese Unexamined Patent Application Publication No. 2009-186905

### Summary of Invention

### Technical Problem

However, even when the light-shielding member for a through-hole packaged LED disclosed in Patent Literature 2 is applied to a transparent display device using an LED element with an area of 10,000 µm² or less, leakage to the rear-face side of light emitted from the LED element cannot be sufficiently suppressed.

The present invention has been made in consideration of such circumstances and an object thereof is to provide a transparent display device capable of suppressing leakage to a rear-face side of light emitted from an LED element.

### Solution to Problem

The present invention provides a transparent display device configured as described in [1] below.
[1] A transparent display device, comprising:
   a transparent substrate; and
   a light-emitting diode element arranged for each pixel on the transparent substrate,
   a rear-face side of the transparent display device being visually recognizable from a viewing side, in which
   the light-emitting diode element is a semiconductor chip with an area of 10,000 µm² or less, and
   a main surface on the rear-face side in the light-emitting diode element is covered by a light-shielding film.

   In an aspect of the present invention,
[2] the transparent display device according to [1], in which the light-shielding film is configured to cover an entire main surface on the rear-face side of the light-emitting diode element and formed so as to protrude from the main surface.
[3] The transparent display device according to [1] or [2], in which internal transmittance of visible light in a transparent member positioned more toward the rear-face side than the light-shielding film is 90% or less.
[4] The transparent display device according to [3], in which the transparent substrate is the transparent member.
[5] The transparent display device according to [4], further comprising: a protective layer configured to cover the light-emitting diode element on the transparent substrate; and an antireflective film formed on the protective layer.
[6] The transparent display device according to [3], further comprising: a protective layer configured to cover the light-emitting diode element on the transparent substrate, in which
   the protective layer is the transparent member.
[7] The transparent display device according to [6], further comprising: an antireflective film formed on a main surface on the viewing side in the transparent substrate.
[8] The transparent display device according to [1] or [2], further comprising, more toward the rear-face side than the light-shielding film, a light control layer configured to be capable of dynamically adjusting internal transmittance of visible light.
[9] The transparent display device according to any one of [1] to [8], further comprising a mirror structure formed so as to surround the light-emitting diode element.
[10] The transparent display device according to any one of [1] to [9], in which an entire main surface on the viewing side in the light-emitting diode element is covered by a lens.
   The present invention provides a laminated glass configured as described in [11] below.
[11] A laminated glass, comprising:
   a pair of glass plates; and
   a transparent display device provided between the pair of glass plates, in which
   the transparent display device includes:
      a transparent substrate; and
      a light-emitting diode element arranged for each pixel on the transparent substrate,
      a rear-face side of the transparent display device being visually recognizable from a viewing side,
      the light-emitting diode element is a semiconductor chip with an area of 10,000 µm² or less, and
      a main surface on the rear-face side in the light-emitting diode element is covered by a light-shielding film.
      The present invention provides a manufacturing method of a transparent display device configured as described in [12] below.
[12] A manufacturing method of a transparent display device of which a rear-face side is visually recognizable from a viewing side, the manufacturing method comprising:
   arranging a light-emitting diode element being a semiconductor chip having an area of 10,000 µm² or less for each pixel on a transparent substrate; and
   covering a main surface on the rear-face side in the light-emitting diode element with a light-shielding film.

### Advantageous Effect of Invention

According to the present invention, a transparent display device capable of suppressing leakage to a rear-face side of light emitted from an LED element can be provided.

### Brief Description of Drawings

Fig. 1 is a schematic partial plan view showing an example of a transparent display device according to a first embodiment;
Fig. 2 is an enlarged view of a region II in Fig. 1;
Fig. 3 is a sectional view taken along a cut line III-III in Fig. 2;
Fig. 4 is a sectional view showing an example of a manufacturing method of the transparent display device according to the first embodiment;
Fig. 5 is a sectional view showing an example of a manufacturing method of the transparent display device according to the first embodiment;
Fig. 6 is a sectional view showing an example of a manufacturing method of the transparent display device according to the first embodiment;
Fig. 7 is a sectional view showing an example of a manufacturing method of the transparent display device according to the first embodiment;
Fig. 8 is a sectional view showing an example of a manufacturing method of the transparent display device according to the first embodiment;
Fig. 9 is a sectional view showing an example of a manufacturing method of the transparent display device according to the first embodiment;
Fig. 10 is a sectional view showing an example of a manufacturing method of the transparent display device according to the first embodiment;
Fig. 11 is a sectional view showing an example of a manufacturing method of the transparent display device according to the first embodiment;
Fig. 12 is a sectional view showing an example of a manufacturing method of the transparent display device according to the first embodiment;
Fig. 13 is a schematic partial plan view showing an example of a transparent display device according to a modified example of the first embodiment;
Fig. 14 is a sectional view taken along a cut line XIV-XIV in Fig. 13;
Fig. 15 is a schematic partial sectional view showing an example of a transparent display device according to a second embodiment;
Fig. 16 is a schematic partial plan view showing an example of a transparent display device according to a third embodiment;
Fig. 17 is a sectional view taken along a cut line XVII-XVII in Fig. 16;
Fig. 18 is a schematic partial sectional view showing an example of a transparent display device according to a modified example of the third embodiment;
Fig. 19 is a schematic partial sectional view showing an example of a transparent display device according to a fourth embodiment;
Fig. 20 is a schematic plan view showing an example of a laminated glass according to a fifth embodiment;
Fig. 21 is a schematic sectional view showing an example of the laminated glass according to the fifth embodiment; and
Fig. 22 is a schematic sectional view showing another example of the laminated glass according to the fifth embodiment.

### Description of Embodiments

Hereinafter, specific embodiments to which the present invention has been applied will be described in detail with reference to the drawings. However, the present invention is not limited to the following embodiments. In addition, for the sake of brevity, the following descriptions and the drawings have been simplified as appropriate.

In the present specification, a "transparent display device" refers to a display device which causes visual information related to a person, a background, or the like positioned on a rear-face side of the display device to be visually recognizable under a desired use environment. Note that whether or not visually recognizable is determined in a state where at least the display device is not displayed or, in other words, the display device is not energized.

In the present specification, "transparent" refers to transmittance of visible light being 40% or higher, preferably 60% or higher, and more preferably 70% or higher. Alternatively, "transparent" may refer to transmittance being 5% or higher and a haze value being 20 or smaller. A transmittance of 5% or higher enables outdoors to be viewed with a brightness equal to or higher than indoors when the outdoors is viewed from indoors during the day and enables superior visibility to be secured.

In addition, a transmittance of 40% or higher enables the rear-face side of the transparent display device to be substantially visually recognized without incident even when brightness on a front-face side and brightness on the rear-face side of the transparent display device are more or less the same. Furthermore, a haze value of 10 or smaller enables contrast of the background to be sufficiently secured.

"Transparency" is realized regardless of whether color is imparted or not or, in other words, "transparent" may refer to being colorless and transparent or being colored and transparent.

Note that transmittance refers to a value (%) measured by a method conforming to ISO 9050. A haze value refers to a value measured by a method conforming to ISO 14782.

### (First embodiment)

### <Configuration of transparent display device>

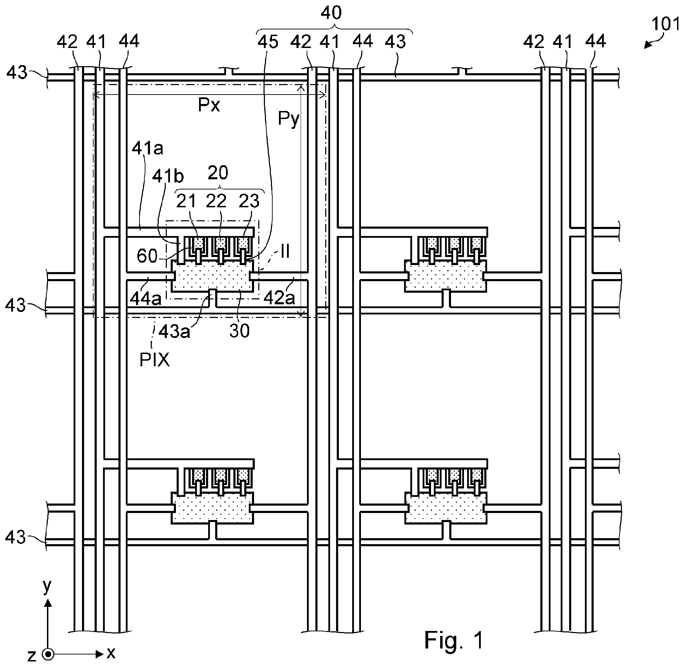

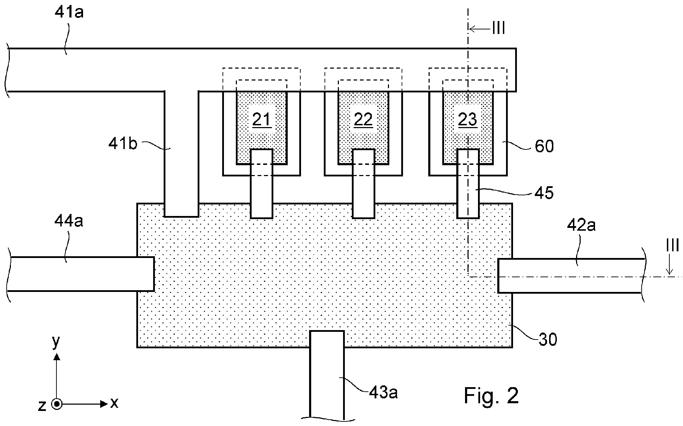

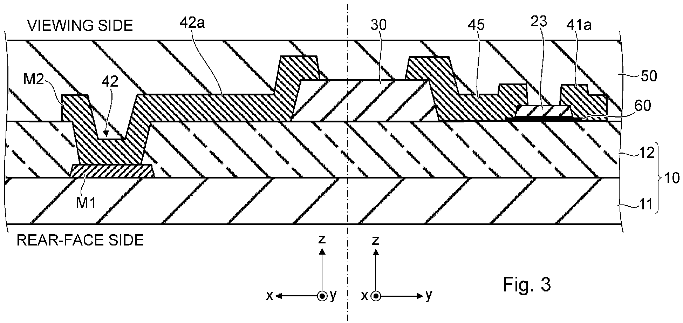

First, a configuration of a transparent display device according to a first embodiment will be explained with reference to Fig. 1 to Fig. 3. Fig. 1 is a schematic partial plan view showing an example of the transparent display device according to the first embodiment. Fig. 2 is an enlarged view of a region II in Fig. 1. Fig. 3 is a sectional view taken along a cut line III-III in Fig. 2.

As shown in Fig. 1 to Fig. 3, the transparent display device according to the present embodiment includes a transparent substrate 10, a light-emitting unit 20, an IC (Integrated Circuit) chip 30, a wiring 40, a protective layer 50, and a light-shielding film 60. A display region 101 in the transparent display device is a region which is constituted of a plurality of pixels and in which images are to be displayed. Note that images include characters. As shown in Fig. 1, the display region 101 is constituted of a plurality of pixels arranged in a row direction (x-axis direction) and a column direction (y-axis direction). Fig. 1 shows a part of the display region 101 and shows a total of four pixels constituted of two pixels respectively in the row direction and the column direction. In this case, one pixel PIX is shown enclosed by a dashed-dotted line.

It should be understood that right-handed system xyz orthogonal coordinates shown in Fig. 1 to Fig. 3 are provided for the sake of convenience in order to explain positional relationships among constituent elements. Usually, a positive z-axis direction is vertically upward and an xy plane is a horizontal plane.

In addition, in Fig. 1 and Fig. 2, the transparent substrate 10 and the protective layer 50 shown in Fig. 3 are omitted. Furthermore, although Fig. 1 and Fig. 2 are plan views, the light-emitting unit 20 and the IC chip 30 are displayed by dots in order to facilitate understanding.

### <Planar arrangement of light-emitting unit 20, IC chip 30, wiring 40, and light-shielding film 60>

First, a planar arrangement of the light-emitting unit 20, the IC chip 30, the wiring 40, and the light-shielding film 60 will be described with reference to Fig. 1 and Fig. 2.

As shown in Fig. 1, the pixel PIX enclosed by a dashed-dotted line is arranged in a matrix pattern at a pixel pitch Px in the row direction (x-axis direction) and at a pixel pitch Py in the column direction (y-axis direction). In this case, as shown in Fig. 1, each pixel PIX includes the light-emitting unit 20 and the IC chip 30. In other words, the light-emitting unit 20 and the IC chip 30 are arranged in a matrix pattern at the pixel pitch Px in the row direction (x-axis direction) and at the pixel pitch Py in the column direction (y-axis direction).

Note that an arrangement format of the pixel PIX or, in other words, the light-emitting unit 20 is not limited to a matrix pattern as long as the pixel PIX or the light-emitting unit 20 is arranged at a predetermined pixel pitch in a predetermined direction.

As shown in Fig. 1, the light-emitting unit 20 in each pixel PIX includes at least one light-emitting diode element (hereinafter, an LED element). In other words, the transparent display device according to the present embodiment is a display device using an LED element in each pixel PIX and is referred to as an LED display or the like.

In the example shown in Fig. 1, each light-emitting unit 20 includes a red-colored LED element 21, a green-colored LED element 22, and a blue-colored LED element 23. The LED elements 21 to 23 correspond to sub-pixels which constitute a single pixel. In this manner, since each light-emitting unit 20 has the LED elements 21 to 23 which emit light in the colors of red, green, and blue being the three primary colors of light, the transparent display device according to the present embodiment can display a full-color image.

Note that each light-emitting unit 20 may include two or more LED elements of a same color. Accordingly, a dynamics range of an image can be expanded.

The LED elements 21 to 23 are so-called micro LED elements which are semiconductor chips with an area of 10,000 µm² or less. Specifically, a width (a length in the x-axis direction) and a length (a length in the y-axis direction) of the LED element 21 on the transparent substrate 10 are, respectively, for example, 100 µm or less, preferably 50 µm or less, and more preferably 20 µm or less. A similar description applies to the LED elements 22 and 23. Due to various manufacturing conditions and the like, a lower limit of the width and the length of the LED elements is, for example, 3 µm or more.

Note that while dimensions or, in other words, the widths and the lengths of the LED elements 21 to 23 in Fig. 1 are the same, the widths and the lengths may differ from one another.

In addition, an area of the LED elements 21 to 23 on the transparent substrate 10 is preferably 3,000 µm² or less and more preferably 500 µm² or less. Due to various manufacturing conditions and the like, a lower limit of the area occupied by one LED element is, for example, 10 µm² or more. In the present specification, an area of an LED element or an area of a constituent member such as a wiring indicates an area occupied by the LED element or the constituent member such as a wiring in an xy plan view in Fig. 1.

While a shape of the LED elements 21 to 23 shown in Fig. 1 is a rectangular shape (including a square shape), the shape of the LED elements 21 to 23 is not particularly limited.

In this case, for example, transmittance of the LED elements 21 to 23 is low at around 10% or lower. However, in the transparent display device according to the present embodiment, as described earlier, the LED elements 21 to 23 with a minute size of which an area is 10,000 µm² or less are used. Therefore, for example, even when the transparent display device is observed from a short distance of around several 10 cm to 2 m, the LED elements 21 to 23 are hardly visually recognizable. In addition, a region with low transmittance in the display region 101 is narrow and superior visibility of the rear-face side can be secured. Furthermore, a degree of freedom of an arrangement of the wiring 40 and the like is also high.

Note that "a region with low transmittance in the display region 101" is, for example, a region of which transmittance is 20% or lower. A similar description applies hereinafter.

In addition, since the LED elements 21 to 23 with a minute size are used, the LED elements are less susceptible to damage even when the transparent display device is bent. Therefore, the transparent display device according to the present embodiment can be used by mounting the transparent display device to a curved transparent plate such as a window glass for a vehicle or sealing the transparent display device between two curved transparent plates. In this case, using a material with flexibility as the transparent substrate 10 enables the transparent display device according to the present embodiment to be curved.

Although not particularly limited, the LED elements 21 to 23 are made of, for example, inorganic materials. For example, the red-colored LED element 21 is made of AlGaAs, GaAsP, GaP, or the like. For example, the green-colored LED element 22 is made of InGaN, GaN, AlGaN, GaP, AlGaInP, ZnSe, or the like. For example, the blue-colored LED element 23 is made of InGaN, GaN, AlGaN, ZnSe, or the like. In addition, the LED elements 21 to 23 may be configured to not only emit unpolarized light but to also emit polarized light. A function of emitting polarized light is realized by providing a structure with a shorter pitch than a wavelength of light to be emitted inside or on a surface of the LED elements 21 to 23, providing a material with chirality inside or on a surface of the LED elements 21 to 23, or the like. Furthermore, when the LED elements 21 to 23 emit polarized light, arranging a member such as a polarizing film which absorbs or reflects specific polarized light on the rear-face side is preferable since light leaking to the rear-face side can be suppressed. The polarizing film may act on any of linear polarized light and circular polarized light.

Luminous efficiency or, in other words, energy conversion efficiency of the LED elements 21 to 23 is, for example, 1% or higher, preferably 5% or higher, and more preferably 15% or higher. When the luminous efficiency of the LED elements 21 to 23 is 1% or higher, sufficient brightness is obtained even with the LED elements 21 to 23 having minute sizes as described above and the LED elements 21 to 23 can be used as a display device even during the day. In addition, when the luminous efficiency of the LED elements is 15% or higher, heat generation is suppressed and the LED elements can be readily sealed inside a laminated glass using a resin adhesion layer.

The pixel pitches Px and Py are, respectively, for example, 100 to 3,000 µm, preferably 180 to 1,000 µm, and more preferably 250 to 400 µm. Setting the pixel pitches Px and Py to the range described above enables high transparency to be realized while securing sufficient display capability. In addition, a diffraction phenomenon which may occur due to light from the rear-face side of the transparent display device can be suppressed.

Furthermore, a pixel density in the display region 101 of the transparent display device according to the present embodiment is, for example, 10 ppi or higher, preferably 30 ppi or higher, and more preferably 60 ppi or higher.

In addition, an area of one pixel PIX is expressed as Px × Py. An area of one pixel is, for example, 1 × 10⁴ µm² to 9 × 10⁶ µm², preferably 3 × 10⁴ µm² to 1 × 10⁶ µm², and more preferably 6 × 10⁴ µm² to 2 × 10⁵ µm². Setting the area of one pixel to 1 × 10⁴ µm² to 9 × 10⁶ µm² enables transparency of the display device to be improved while securing suitable display capability. The area of one pixel may be appropriately selected based on a size, a usage, a visual recognition distance, or the like of the display region 101.

A percentage of the area occupied by the LED elements 21 to 23 with respect to the area of one pixel is, for example, 30% or less, preferably 10% or less, more preferably 5% or less, and even more preferably 1% or less. Setting the percentage of the area occupied by the LED elements 21 to 23 with respect to the area of one pixel to 30% or less improves transparency and visibility of the rear-face side.

In Fig. 1, while the three LED elements 21 to 23 are arranged in a single row in the positive x-axis direction in this order in each pixel, the arrangement of the LED elements 21 to 23 is not limited thereto. For example, the arrangement order of the three LED elements 21 to 23 may be changed. In addition, the three LED elements 21 to 23 may be arranged in the y-axis direction. Alternatively, the three LED elements 21 to 23 may be arranged at vertices of a triangle.

Furthermore, as shown in Fig. 1, when each light-emitting unit 20 includes a plurality of LED elements 21 to 23, intervals among the LED elements 21 to 23 in the light-emitting unit 20 is, for example, 100 µm or less and, preferably, 10 µm or less. Alternatively, the LED elements 21 to 23 may be arranged in contact with each other. Accordingly, a first power supply branch line 41a can be more readily standardized and a numerical aperture can be improved.

While an arrangement order, an arrangement direction, and the like of the plurality of LED elements in each light-emitting unit 20 are the same in the example shown in Fig. 1, the arrangement order, the arrangement direction, and the like may differ among light-emitting units 20. In addition, when each light-emitting unit 20 includes three LED elements which emit light with different wavelengths, the LED elements may be arranged lined up in the x-axis direction or the y-axis direction in a part of the light-emitting units 20 while the LED elements of the respective colors may be arranged at vertices of a triangle in other light-emitting units 20.

In the example shown in Fig. 1, the IC chip 30 is arranged in each pixel PIX and drives the light-emitting unit 20. Specifically, the IC chip 30 is connected to each of the LED elements 21 to 23 with a drive line 45 interposed therebetween and can individually drive the LED elements 21 to 23. For example, the IC chip 30 is a hybrid IC including an analog region and a logic region. For example, the analog region includes an electrical current control circuit and a transformer circuit.

Alternatively, the IC chip 30 may be arranged for every plurality of pixels and each IC chip 30 may drive the plurality of pixels to which the IC chip 30 is connected. For example, by arranging one IC chip 30 for every four pixels, the number of IC chips 30 can be reduced to 1/4 as compared to the example shown in Fig. 1 and an area occupied by the IC chips 30 can be reduced. In addition, the IC chips 30 are not essential.

An area of the IC chip 30 is, for example, 100,000 µm² or less, preferably 10,000 µm² or less, and more preferably 5,000 µm² or less. While a transmittance of the IC chip 30 is low at around 20% or less, using the IC chip 30 with the size described above narrows a region with low transmittance in the display region 101 and improves visibility of the rear-face side.

As shown in Fig. 1, the wiring 40 has a plurality of each of a power supply line 41, a ground line 42, a row data line 43, a column data line 44, and the drive line 45.

In the example shown in Fig. 1, the power supply line 41, the ground line 42, and the column data line 44 are extended in the y-axis direction. On the other hand, the row data line 43 is extended in the x-axis direction.

In addition, in each pixel PIX, the power supply line 41 and the column data line 44 are provided more toward a side of a negative x-axis direction than the light-emitting unit 20 and the IC chip 30 and the ground line 42 is provided more toward a side of the positive x-axis direction than the light-emitting unit 20 and the IC chip 30. In this case, the power supply line 41 is provided more toward the side of the negative x-axis direction than the column data line 44. In addition, in each pixel PIX, the row data line 43 is provided more toward a side of the negative y-axis direction than the light-emitting unit 20 and the IC chip 30.

Furthermore, while details will be provided later, as shown in Fig. 1, the power supply line 41 includes the first power supply branch line 41a and a second power supply branch line 41b. The ground line 42 includes a ground branch line 42a. The row data line 43 includes a row data branch line 43a. The column data line 44 includes a column data branch line 44a. The respective branch lines are included in the wiring 40.

As shown in Fig. 1, each power supply line 41 extended in the y-axis direction is connected to the light-emitting unit 20 and the IC chip 30 of each pixel PIX arranged in the y-axis direction. More specifically, in each pixel PIX, on the side of the positive x-axis direction of the power supply line 41, the LED elements 21 to 23 are arranged in the positive x-axis direction in this order. Therefore, the first power supply branch line 41a which branches in the positive x-axis direction from the power supply line 41 is connected to end parts on a side of the positive y-axis direction of the LED elements 21 to 23.

In addition, in each pixel PIX, the IC chip 30 is provided more toward a side of the negative y-axis direction than the LED elements 21 to 23. Therefore, between the LED element 21 and the column data line 44, the second power supply branch line 41b having been branched in the negative y-axis direction from the first power supply branch line 41a is linearly extended and connected to a side in the negative x-axis direction of the end part on a side of the positive y-axis direction of the IC chip 30.

As shown in Fig. 1, each ground line 42 extended in the y-axis direction is connected to the IC chip 30 of each pixel PIX arranged in the y-axis direction. Specifically, the ground branch line 42a having been branched in the negative x-axis direction from the ground line 42 is linearly extended and connected to an end part on a side of the positive x-axis direction of the IC chip 30.

In this case, the ground line 42 is connected to the LED elements 21 to 23 with the ground branch line 42a, the IC chip 30, and the drive line 45 interposed therebetween.

As shown in Fig. 1, each row data line 43 extended in the x-axis direction is connected to the IC chip 30 of each pixel PIX arranged in the x-axis direction (the row direction). Specifically, the row data branch line 43a having been branched in the positive y-axis direction from the row data line 43 is linearly extended and connected to an end part on a side of the negative y-axis direction of the IC chip 30.

In this case, the row data line 43 is connected to the LED elements 21 to 23 with the row data branch line 43a, the IC chip 30, and the drive line 45 interposed therebetween.

As shown in Fig. 1, each column data line 44 extended in the y-axis direction is connected to the IC chip 30 of each pixel PIX arranged in the y-axis direction (the column direction). Specifically, the column data branch line 44a having been branched in the positive x-axis direction from the column data line 44 is linearly extended and connected to an end part on a side of the negative x-axis direction of the IC chip 30.

In this case, the column data line 44 is connected to the LED elements 21 to 23 with the column data branch line 44a, the IC chip 30, and the drive line 45 interposed therebetween.

The drive line 45 connects the LED elements 21 to 23 and the IC chip 30 to each other in each pixel PIX. Specifically, in each pixel PIX, three drive lines 45 are extended in the y-axis direction, and each drive line 45 connects end parts on a side of the negative y-axis direction of the LED elements 21 to 23 and an end part on a side of the positive y-axis direction of the IC chip 30 to each other.

Note that the arrangements of the power supply line 41, the ground line 42, the row data line 43, the column data line 44, branch lines thereof, and the drive line 45 shown in Fig. 1 are merely examples and can be changed as appropriate. For example, at least one of the power supply line 41 and the ground line 42 may be extended in the x-axis direction instead of the y-axis direction. In addition, a configuration in which the power supply line 41 and the column data line 44 are interchanged may be adopted.

Furthermore, a configuration in which the entire configuration shown in Fig. 1 is vertically inverted or horizontally inverted may be adopted.

Moreover, the row data line 43, the column data line 44, branch lines thereof, and the drive line 45 are not essential.

For example, the wiring 40 is made of a metal such as copper (Cu), aluminum (Al), silver (Ag), or gold (Au). Among these metals, a metal containing copper or aluminum as a main component is preferable due to low resistivity and from a cost perspective. In addition, the wiring 40 may be coated with a material such as titanium (Ti), molybdenum (Mo), copper oxide, or carbon for the purpose of reducing reflectance. Furthermore, irregularities may be formed on a surface of the coated material.

All of the widths of the wiring 40 in the display region 101 shown in Fig. 1 are, for example, 1 to 100 µm and, preferably, 3 to 20 µm. Since the width of the wiring 40 is 100 µm or less, for example, even when the transparent display device is observed from a short distance of around several 10 cm to 2 m, the wiring 40 is hardly visually recognizable and superior visibility of the rear-face side can be secured. On the other hand, in a case of a range of thickness to be described later, when the width of the wiring 40 is 1 µm or more, an excessive rise in resistance of the wiring 40 can be suppressed and a voltage drop or a decline in signal strength can be suppressed. In addition, a decline in thermal conductivity due to the wiring 40 can also be suppressed.

When the wiring 40 is mainly extended in the x-axis direction and the y-axis direction as shown in Fig. 1, a cross diffraction pattern extending in the x-axis direction and the y-axis direction may be created by light radiated from outside of the transparent display device and may cause a decline in visibility of the rear-face side of the transparent display device. Reducing the width of each wiring enables the diffraction to be suppressed and the visibility of the rear-face side to be further improved. From the perspective of suppressing the diffraction, the width of the wiring 40 may be 50 µm or less, preferably 10 µm or less, and more preferably 5 µm or less.

Electrical resistivity of the wiring 40 is, for example, 1.0 × 10⁻⁶ S2m or less and preferably 2.0 × 10⁻⁸ S2m or less. In addition, thermal conductivity of the wiring 40 is, for example, 150 to 5,500 W/(m•K) and preferably 350 to 450 W/(m•K).

Intervals between adjacent wirings 40 in the display region 101 shown in Fig. 1 are, for example, 3 to 100 µm and, preferably, 5 to 30 µm. The presence of a region where the wiring 40 is closely packed may inhibit visual recognition of the rear-face side. Setting the intervals between adjacent wirings 40 to 3 µm or more enables such inhibition of visual recognition to be suppressed. On the other hand, setting the intervals between adjacent wirings 40 to 100 µm or less enables sufficient display capability to be secured.

Note that when intervals between wirings 40 are not constant due to the wirings 40 being curved or the like, the intervals between the adjacent wirings 40 described above refer to a minimum value of the intervals.

A percentage of the area occupied by the wiring 40 with respect to the area of one pixel is, for example, 30% or less, preferably 10% or less, more preferably 5% or less, and even more preferably 3% or less. The transmittance of the wiring 40 is low at, for example, 20% or less or 10% or less. However, by setting the area occupied by the wiring 40 in one pixel to 30% or less, a region with low transmittance in the display region 101 narrows and the visibility of the rear-face side improves.

Furthermore, a sum of areas occupied by the light-emitting unit 20, the IC chip 30, and the wiring 40 with respect to the area of one pixel is, for example, 30% or less, preferably 20% or less, and more preferably 10% or less.

The light-shielding film 60 is formed so as to cover an entire main surface on the rear-face side in each of the LED elements 21 to 23. Therefore, as shown in Fig. 2, each light-shielding film 60 is formed so as to overlap with an entirety of each of the LED elements 21 to 23 in an xy plan view. By covering the main surface on the rear-face side of each of the LED elements 21 to 23 with the light-shielding film 60 in this manner, leakage to the rear-face side of light emitted from the LED elements 21 to 23 can be suppressed. The light-shielding film 60 preferably covers the entire main surface on the rear-face side.

For example, the light-shielding film 60 is a black resin film, a metal oxide film, a metal nitride film, or the like with insulation properties. More specifically, for example, the light-shielding film 60 is a black resist film, a carbon-based material such as carbon black, a film in which Cr, Mo, Ti, Al, or the like is entirely or partially oxidized or nitrided, and the like. The light-shielding film 60 may be a metallic film with conductivity such as a metal Cr film. In addition, a resin containing a filler of such a material may be used as the light-shielding film 60. Furthermore, preferably, an effective refractive index of the resin containing a filler is comparable to a refractive index of the surrounding transparent substrate 10 or the protective layer 50 or a difference in refractive indices is within 0.2. Moreover, in order to suppress reflection of light by the light-shielding film 60, a surface of the light-shielding film 60 is preferably not smooth.

As shown in Fig. 2, the light-shielding film 60 may be formed so as to protrude from the main surface on the rear-face side of each of the LED elements 21 to 23. Light emitted from the LED elements 21 to 23 to the viewing side and reflected to the rear-face side can be prevented from leaking to the rear-face side by the light-shielding film 60 protruding from the LED elements 21 to 23.

Although the larger the area of the light-shielding film 60, the greater the suppression of leakage of such reflected light to the rear-face side, visibility of the rear-face side declines. Therefore, for example, the area of the light-shielding film 60 is 0.6 times the area of one pixel or less, preferably 0.4 times or less, and more preferably 0.2 times or less.

### <Sectional configuration of transparent display device>

Next, a sectional configuration of the transparent display device according to the present embodiment will be explained with reference to Fig. 3.

The transparent substrate 10 is made of a transparent material with insulation properties. In the example shown in Fig. 3, the transparent substrate 10 has a two-layer structure including a main substrate 11 and an adhesive layer 12.

As will be described in detail later, the main substrate 11 is made of, for example, a transparent resin.

The adhesive layer 12 is made of, for example, a transparent resin adhesive such as an epoxy-based adhesive, an acrylic adhesive, an olefin-based adhesive, a polyimide-based adhesive, or a novolac-based adhesive.

Alternatively, the main substrate 11 may be a thin glass plate with a thickness of, for example, 200 µm or less and, preferably, 100 µm or less. In addition, the adhesive layer 12 is not essential.

Examples of the transparent resin which constitutes the main substrate 11 include: a polyester-based resin such as polyethylene terephthalate (PET) or polyethylene naphthalate (PEN); an olefin-based resin such as a cycloolefin polymer (COP) or a cycloolefin copolymer (COC); a cellulose-based resin such as cellulose, acetyl cellulose, or triacetyl cellulose (TAC); an imide-based resin such as polyimide (PI); an amide-based resin such as polyamide (PA); an amide-imide-based resin such as polyamide-imide (PAI); a carbonate-based resin such as polycarbonate (PC); a sulfone-based resin such as polyether sulfone (PES); a paraxylene-based resin such as poly-paraxylene; a vinyl-based resin such as polyethylene (PE), polyvinyl chloride (PVC), polystyrene (PS), polyvinyl acetate (PVAc), polyvinyl alcohol (PVA), or polyvinyl butyral (PVB); an acrylic resin such as polymethylmethacrylate (PMMA); an ethylene-vinyl acetate copolymer resin (EVA); a urethane-based resin such as thermoplastic polyurethane (TPU); and an epoxy-based resin.

Among the materials which may be used in the main substrate 11 described above, polyethylene naphthalate (PEN) or polyimide (PI) is preferable from the perspective of improving heat resistance. In addition, a cycloolefin polymer (COP), a cycloolefin copolymer (COC), polyvinyl butyral (PVB), or the like is preferable in terms of a low birefringence index and an ability to reduce distortion or blurring of an image viewed through the transparent substrate.

The materials described above may be used alone or two or more may be used in combination. Furthermore, the main substrate 11 may be constructed by laminating flat plates made of different materials.

A thickness of the entire transparent substrate 10 is, for example, 3 to 1,000 µm and, preferably, 5 to 200 µm.

In addition, the transparent substrate 10 may have flexibility. Accordingly, for example, the transparent display device can be used by mounting the transparent display device to a curved transparent plate or by sandwiching the transparent display device between two curved transparent plates. Furthermore, the transparent substrate 10 may be made of a material which contracts when heated to 100°C or higher.

As shown in Fig. 3, the LED elements 21 to 23 and the IC chip 30 are provided on the transparent substrate 10 or, in other words, the adhesive layer 12.

In this case, as shown in Fig. 3, the LED elements 21 to 23 are provided on the transparent substrate 10 or, in other words, the adhesive layer 12 with the light-shielding film 60 interposed therebetween. In other words, the light-shielding film 60 is formed on the transparent substrate 10, that is, the adhesive layer 12, and the LED elements 21 to 23 are formed on the light-shielding film 60. In the example shown in Fig. 3, a side of a positive z-axis direction is the viewing side and a side of a negative z-axis direction is the rear-face side. Therefore, the entire main surface on the rear-face side is covered by the light-shielding film 60 in each of the LED elements 21 to 23 and light emitted from the LED elements 21 to 23 can be prevented from directly leaking to the rear-face side. Scattering on a side wall of the light-shielding film 60 can be suppressed when a thickness of the light-shielding film 60 is, for example, 0.01 to 2 µm. The thickness of the light-shielding film 60 is preferably 0.5 µm or less and more preferably 0.1 µm or less.

As shown in Fig. 3, the transparent substrate 10 is positioned more toward the rear-face side than the light-shielding film 60. In consideration thereof, in order to prevent light emitted from the LED elements 21 to 23 to the viewing side and reflected to the rear-face side from leaking to the rear-face side, internal transmittance of visible light of the transparent substrate 10 may be set to, for example, 90% or lower. From such a perspective, the internal transmittance of visible light of the transparent substrate 10 is preferably 70% or lower and more preferably 50% or lower. In this case, the transparent substrate 10 may only absorb light in a partial wavelength range among visible light or may absorb light in the entire wavelength range of visible light.

As shown in Fig. 3, the LED elements 21 to 23 and the IC chip 30 are connected to the wiring 40 which is arranged on the transparent substrate 10. In the example shown in Fig. 3, the wiring 40 is constituted of a first metal layer M1 formed on the main substrate 11 and a second metal layer M2 formed on the adhesive layer 12.

A thickness of the wiring 40 or, in other words, a sum of a thickness of the first metal layer M1 and a thickness of the second metal layer M2 is, for example, 0.1 to 10 µm and, preferably, 0.5 to 5 µm. The thickness of the first metal layer M1 is, for example, around 0.5 µm, and the thickness of the second metal layer M2 is, for example, around 3 µm.

Specifically, as shown in Fig. 3, since an amount of an electrical current in the ground line 42 extended in the y-axis direction is large, the ground line 42 has a two-layer structure including the first metal layer M1 and the second metal layer M2. In other words, in a location where the ground line 42 is provided, the adhesive layer 12 is removed and the second metal layer M2 is formed on top of the first metal layer M1. Although not shown in Fig. 3, the power supply line 41, the row data line 43, and the column data line 44 shown in Fig. 1 similarly have two-layer structures including the first metal layer M1 and the second metal layer M2.

In this case, as shown in Fig. 1, the power supply line 41, the ground line 42, and the column data line 44 which are extended in the y-axis direction intersect with the row data line 43 which is extended in the x-axis direction. Although not illustrated in Fig. 3, in the intersections, the row data line 43 is solely constituted of the first metal layer M1 and the power supply line 41, the ground line 42, and the column data line 44 are solely constituted of the second metal layer M2. In addition, in the intersections, the adhesive layer 12 is provided between the first metal layer M1 and the second metal layer M2 and the first metal layer M1 and the second metal layer M2 are insulated from each other.

In a similar manner, in the intersections of the column data line 44 and the first power supply branch line 41a shown in Fig. 1, the first power supply branch line 41a is solely constituted of the first metal layer M1 and the column data line 44 is solely constituted of the second metal layer M2.

Furthermore, in the example shown in Fig. 3, the ground branch line 42a, the drive line 45, and the first power supply branch line 41a are solely constituted of the second metal layer M2 and formed so as to cover end parts of the LED elements 21 to 23 and the IC chip 30. Although not illustrated in Fig. 3, the second power supply branch line 41b, the row data branch line 43a, and the column data branch line 44a are similarly solely constituted of the second metal layer M2.

As described above, the first power supply branch line 41a is solely constituted of the first metal layer M1 in intersections with the column data line 44 but solely constituted of the second metal layer M2 in other locations. Alternatively, a metal pad made of copper, silver, gold, or the like may be arranged on the wiring 40 formed on the transparent substrate 10 and at least one of the LED elements 21 to 23 and the IC chip 30 may be arranged on the metal pad.

The protective layer 50 is made of a transparent resin formed on approximately an entire surface of the transparent substrate 10 so as to cover and protect the light-emitting unit 20, the IC chip 30, and the wiring 40.

A thickness of the protective layer 50 is, for example, 3 to 1,000 µm and, preferably, 5 to 200 µm.

A modulus of elasticity of the protective layer 50 is, for example, 10 GPa or lower. A lower modulus of elasticity enables an impact upon separation to be absorbed and suppresses damage to the protective layer 50.

Internal transmittance of visible light of the protective layer 50 is, for example, 50% or higher, preferably 70% or higher, and more preferably 90% or higher.

In order to prevent light from being confined in the protective layer 50 and to extract the light to the viewing side (the side of the positive z-axis direction), the refractive index of the protective layer 50 is preferably lower than a refractive index of a transparent layer (not illustrated in Fig. 3) which the protective layer 50 comes into contact with on the viewing side of the light-emitting unit 20.

On the other hand, when an in-plane average thickness of the protective layer 50 is set smaller than a pitch of one pixel, the refractive index of the protective layer 50 is conversely preferably higher than the refractive index of the transparent layer which the protective layer 50 comes into contact with on the viewing side of the light-emitting unit 20. This is because, by confining light inside the protective layer 50 and guiding the light, light is effectively absorbed by the light-shielding film 60, the wiring 40, and the like which are in contact with the protective layer 50 on the rear-face side and leakage of the light to the rear-face side can be suppressed. In this case, more preferably, the thickness of the protective layer 50 is thinner than a longest side of the light-shielding film 60. Note that even when a transparent layer is further formed between the light-shielding film 60, the wiring 40, or the like and the protective layer 50, a similar effect can be produced if a refractive index of the transparent layer is higher than that of the protective layer 50.

Examples of the transparent resin which constitutes the protective layer 50 include: a vinyl-based resin such as polyethylene (PE), polyvinyl chloride (PVC), polystyrene (PS), polyvinyl acetate (PVAc), polyvinyl alcohol (PVA), or polyvinyl butyral (PVB); an olefin-based resin such as a cycloolefin polymer (COP) or a cycloolefin copolymer (COC); a urethane-based resin such as thermoplastic polyurethane (TPU); a polyester-based region such as polyethylene terephthalate (PET) or polyethylene naphthalate (PEN); an acrylic resin such as polymethylmethacrylate (PMMA); and a thermoplastic resin such as ethylene-vinyl acetate copolymer resin (EVA).

As described above, in the transparent display device according to the present embodiment, the entire main surface on the rear-face side is covered by the light-shielding film 60 in each of the LED elements 21 to 23. Therefore, light emitted from the LED elements 21 to 23 can be prevented from directly leaking to the rear-face side.

In addition, the light-shielding film 60 is formed so as to protrude from the main surface on the rear-face side of the LED elements 21 to 23. Therefore, light emitted from the LED elements 21 to 23 to the viewing side and reflected to the rear-face side can be prevented from leaking to the rear-face side.

Furthermore, by setting internal transmittance of visible light of a transparent member (the transparent substrate 10) positioned more toward the rear-face side than the light-shielding film 60 to 90% or lower, leakage of such reflected light to the rear-face side can be further suppressed.

### <Manufacturing method of transparent display device>

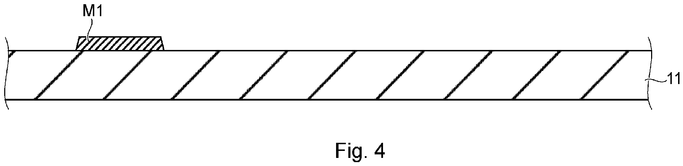

Next, an example of a manufacturing method of the transparent display device according to the first embodiment will be explained with reference to Fig. 3 to Fig. 12. Fig. 4 to Fig. 12 are sectional views showing an example of the manufacturing method of the transparent display device according to the first embodiment. Fig. 4 to Fig. 12 are sectional views corresponding to Fig. 3.

First, as shown in Fig. 4, after forming the first metal layer M1 on approximately an entire surface of the main substrate 11, the first metal layer M1 is patterned by photolithography and a lower-layer wiring is formed. Specifically, the lower-layer wiring is formed by the first metal layer M1 at positions where the power supply line 41, the ground line 42, the row data line 43, the column data line 44, and the like shown in Fig. 1 are to be formed.

Note that the lower-layer wiring is not formed in intersections of the power supply line 41, the ground line 42, and the column data line 44 with the row data line 43.

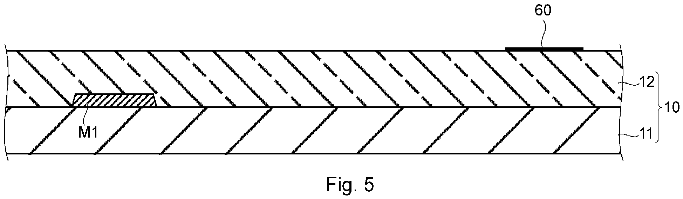

Next, as shown in Fig. 5, after forming the adhesive layer 12 on approximately the entire surface of the main substrate 11, the light-shielding film 60 is patterned on the adhesive layer 12 (in other words, on the transparent substrate 10) having tackiness. In this case, the light-shielding film 60 is formed at positions where the LED elements 21 to 23 are to be mounted.

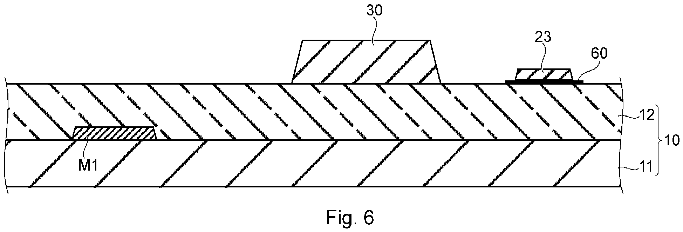

Next, as shown in Fig. 6, the IC chip 30 is mounted on the adhesive layer 12 (in other words, on the transparent substrate 10) and the LED elements 21 to 23 are mounted on the light-shielding film 60. The light-shielding film 60 may have tackiness in a similar manner to the adhesive layer 12.

In this case, the LED elements 21 to 23 are obtained by growing a crystal on a wafer using a liquid phase growth method, an HVPE (hydride vapor phase epitaxy) method, a MOCVD (metal organic chemical vapor deposition) method, or the like and then performing patterning. The LED elements 21 to 23 having been patterned on the wafer are transferred onto the transparent substrate 10 using, for example, a micro-transfer printing technique. In addition, regarding the IC chip 30, for example, the IC chip 30 having been patterned on a Si wafer is transferred onto the transparent substrate 10 using a micro-transfer printing technique in a similar manner to the LED elements 21 to 23.

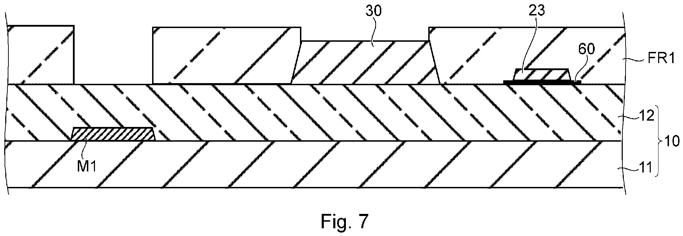

Next, as shown in Fig. 7, after forming a photoresist FR1 on approximately the entire surface of the transparent substrate 10 which includes the main substrate 11 and the adhesive layer 12, the photoresist FR1 on the first metal layer M1 is removed by patterning. At this point, the photoresist FR1 in the intersections of the row data line 43 with the power supply line 41, the ground line 42, and the column data line 44 shown in Fig. 1 are not removed.

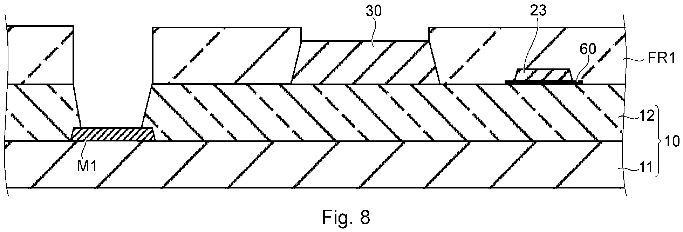

Next, as shown in Fig. 8, the adhesive layer 12 at locations where the photoresist FR1 has been removed is removed by dry etching to expose the first metal layer M1 or, in other words, the lower-layer wiring.

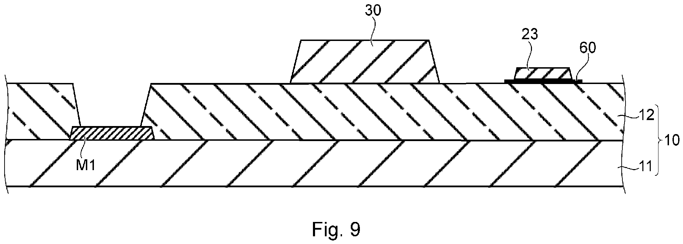

Next, as shown in Fig. 9, all of the photoresist FR1 on the transparent substrate 10 is removed. Subsequently, a seed layer for plating (not illustrated) is formed on approximately the entire surface of the transparent substrate 10.

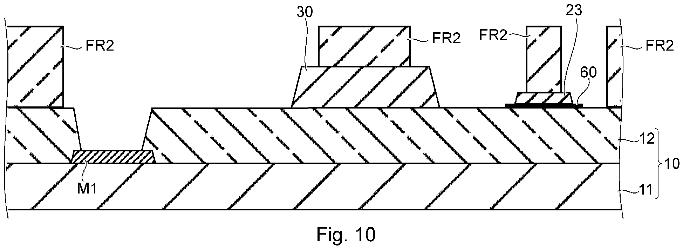

Next, as shown in Fig. 10, after forming a photoresist FR2 on approximately the entire surface of the transparent substrate 10, the photoresist FR2 at locations where an upper-layer wiring is to be formed is removed by patterning to expose the seed layer.

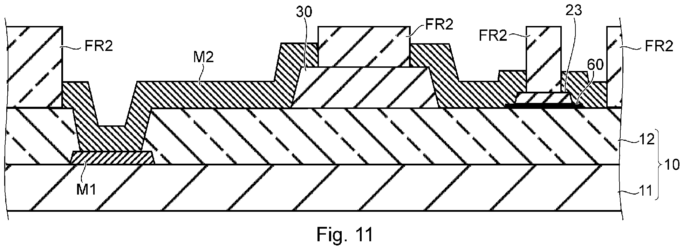

Next, as shown in Fig. 11, the second metal layer M2 is formed by plating on the locations where the photoresist FR2 has been removed or, in other words, on the seed layer. Accordingly, the upper-layer wiring is formed by the second metal layer M2.

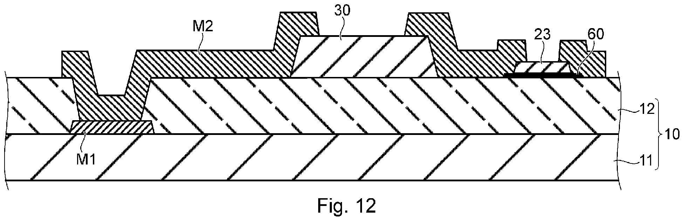

Next, as shown in Fig. 12, the photoresist FR2 is removed. Furthermore, the seed layer having been exposed by removing the photoresist FR2 is removed by etching.

Finally, as shown in Fig. 3, the transparent display device is obtained by forming the protective layer 50 on approximately an entire surface of the transparent substrate 10.

### (Modified example of first embodiment)

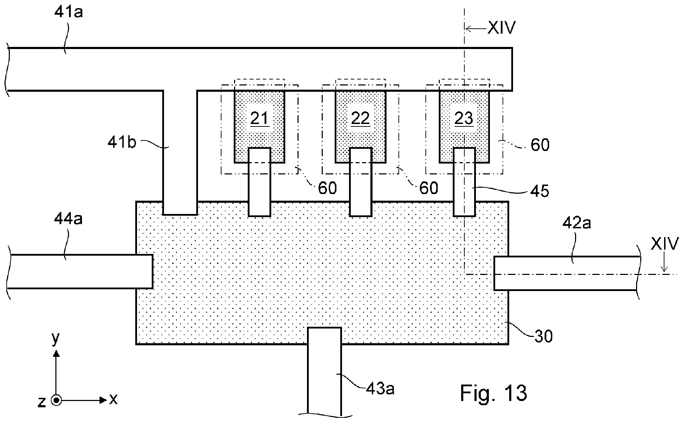

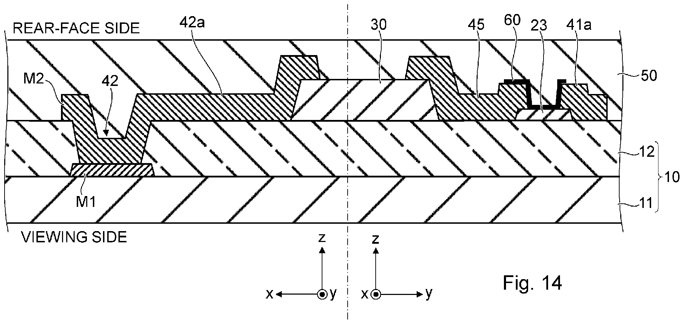

Next, a transparent display device according to a modified example of the first embodiment will be explained with reference to Fig. 13 and Fig. 14. Fig. 13 is a schematic partial plan view which shows an example of a transparent display device according to a modified example of the first embodiment and which is a view corresponding to Fig. 2. Fig. 14 is a sectional view taken along a cut line XIV-XIV in Fig. 13. In Fig. 13, the light-shielding film 60 is drawn by a dashed-two dotted line.

In the example shown in Fig. 2 and Fig. 3, an upper surface side of the LED elements 21 to 23 is the viewing side. Therefore, an entire lower surface of the LED elements 21 to 23 is covered by the light-shielding film 60. By contrast, in the modified example shown in Fig. 13 and Fig. 14, the lower surface side of the LED elements 21 to 23 is the viewing side. Therefore, the upper surface of the LED elements 21 to 23 is covered by the light-shielding film 60. As shown in Fig. 13, an entire upper surface of the LED elements 21 to 23 is covered by the light-shielding film 60, the first power supply branch line 41a, and the drive line 45. In this case, the first power supply branch line 41a and the drive line 45 also function as a light-shielding film.

In addition, as shown in Fig. 14, in the transparent display device according to the modified example, the protective layer 50 is positioned more toward the rear-face side than the light-shielding film 60. In consideration thereof, in order to prevent light emitted from the LED elements 21 to 23 to the viewing side and reflected to the rear-face side from leaking to the rear-face side, internal transmittance of visible light of the protective layer 50 may be set to, for example, 90% or lower. From such a perspective, the internal transmittance of visible light of the protective layer 50 is preferably 70% or lower and more preferably 50% or lower. In this case, the protective layer 50 may only absorb light in a partial wavelength range among visible light or may absorb light in the entire wavelength range of visible light.

On the other hand, in the transparent display device according to the modified example, the transparent substrate 10 is positioned more toward the viewing side than the LED elements 21 to 23. Therefore, internal transmittance of visible light of the transparent substrate 10 is, for example, 50% or higher, preferably 70% or higher, and more preferably 90% or higher.

As described above, even in the transparent display device according to the modified example, the entire main surface on the rear-face side is covered by the light-shielding film 60, the first power supply branch line 41a, and the drive line 45 which function as a light-shielding film in each of the LED elements 21 to 23. Therefore, light emitted from the LED elements 21 to 23 can be prevented from directly leaking to the rear-face side.

In addition, the light-shielding film 60 is formed so as to protrude from the main surface on the rear-face side of the LED elements 21 to 23. Therefore, light emitted from the LED elements 21 to 23 to the viewing side and reflected to the rear-face side can be prevented from leaking to the rear-face side.

Furthermore, by setting internal transmittance of visible light of a transparent member (the protective layer 50) positioned more toward the rear-face side than the light-shielding film 60 to 90% or lower, leakage of such reflected light to the rear-face side can be further suppressed.

The configuration is otherwise similar to that of the transparent display device according to the first embodiment.

### (Second embodiment)

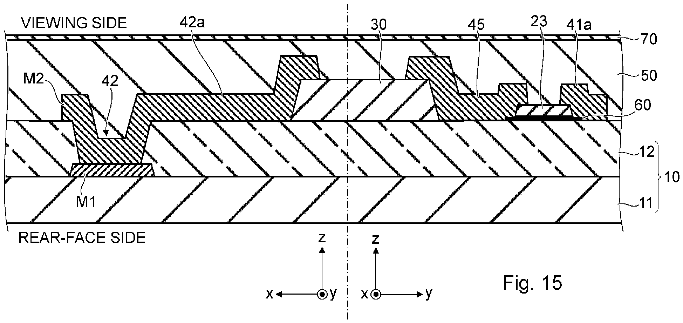

Next, a transparent display device according to a second embodiment will be explained with reference to Fig. 15. Fig. 15 is a schematic partial sectional view which shows an example of the transparent display device according to the second embodiment and which is a view corresponding to Fig. 3.

As shown in Fig. 15, in the transparent display device according to the present embodiment, an antireflective film 70 is formed more toward the viewing side than the LED elements 21 to 23. Specifically, in the transparent display device shown in Fig. 15, the antireflective film 70 is formed on the upper surface (on the main surface on the viewing side) of the protective layer 50 in the transparent display device shown in Fig. 3. Therefore, light emitted from the LED elements 21 to 23 to the viewing side and reflected to the rear-face side by the upper surface of the protective layer 50 can be reduced. As a result, leakage of such reflected light to the rear-face side can be more suppressed than in the transparent display device according to the first embodiment.

The configuration is otherwise similar to that of the transparent display device according to the first embodiment.

Note that a similar effect can be produced even when an antireflective film is formed on the lower surface (on the main surface on the viewing side) of the transparent substrate 10 in the transparent display device shown in Fig. 14.

### (Third embodiment)

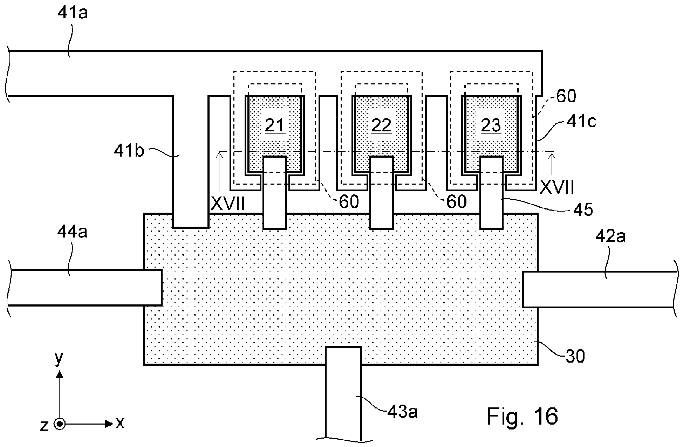

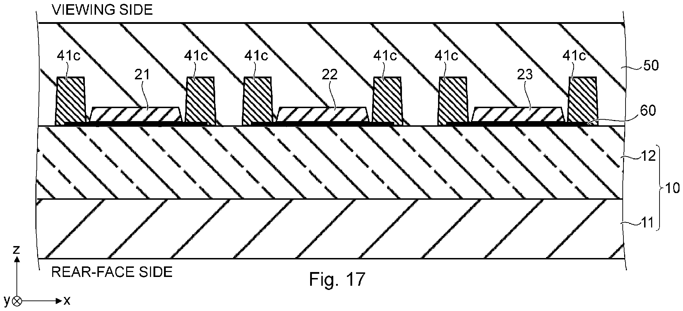

Next, a transparent display device according to a third embodiment will be explained with reference to Fig. 16 and Fig. 17. Fig. 16 is a schematic partial plan view which shows an example of the transparent display device according to the third embodiment and which is a view corresponding to Fig. 2. Fig. 17 is a sectional view taken along a cut line XVII-XVII in Fig. 16.

As shown in Fig. 16, in the transparent display device according to the present embodiment, a third power supply branch line 41c which functions as a mirror structure is formed around each of the LED elements 21 to 23. Specifically, a pair of third power supply branch lines 41c having branched in the negative y-axis direction from the first power supply branch line 41a is formed so as to surround each of the LED elements 21 to 23.

As shown in Fig. 16, each of the LED elements 21 to 23 is entirely surrounded by the first power supply branch line 41a, the pair of third power supply branch lines 41c, and the drive line 45.

Note that the third power supply branch lines 41c and the drive line 45 are separated from each other and are not electrically short-circuited to each other.

As shown in Fig. 17, for example, light emitted from the LED element 23 toward the viewing side so as to spread in an xy plane direction is reflected by wall surfaces of the first power supply branch line 41a, the pair of third power supply branch lines 41c, and the drive line 45 which surround the LED element 23. Therefore, a travel direction of light emitted to the viewing side from the LED element 23 can be brought closer to the positive z-axis direction. A similar description applies to the LED elements 21 and 22.

According to such a configuration, in the transparent display device according to the present embodiment, light emitted from the LED elements 21 to 23 to the viewing side and reflected to the rear-face side by the upper surface of the protective layer 50 can be reduced. As a result, leakage of such reflected light to the rear-face side can be more suppressed than in the transparent display device according to the first embodiment.

The configuration is otherwise similar to that of the transparent display device according to the first embodiment.

Note that the present embodiment and the second embodiment can be combined with each other. In other words, the antireflective film 70 shown in Fig. 15 may be formed on the upper surface of the protective layer 50 shown in Fig. 17.

### (Modified example of third embodiment)

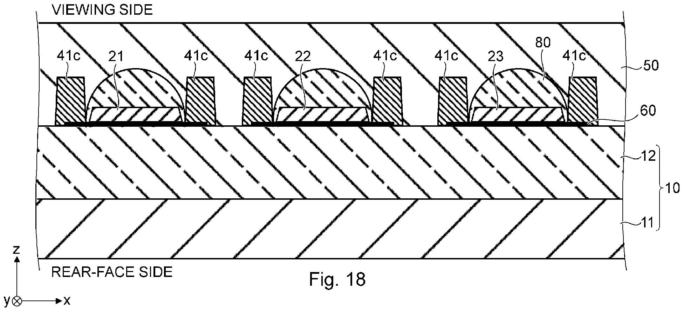

Next, a transparent display device according to a modified example of the third embodiment will be explained with reference to Fig. 18. Fig. 18 is a schematic partial sectional view which shows an example of the transparent display device according to the modified example of the third embodiment and which is a view corresponding to Fig. 17.

As shown in Fig. 18, in the transparent display device according to the modified example, a convex lens 80 which covers the main surface on the viewing side of the LED elements 21 to 23 is formed in the transparent display device shown in Fig. 17. Therefore, a travel direction of light emitted from the LED elements 21 to 23 to the viewing side can be brought even closer to the positive z-axis direction and light reflected to the rear-face side by the upper surface of the protective layer 50 can be reduced. As a result, leakage of such reflected light to the rear-face side can be more suppressed than in the transparent display device shown in Fig. 17.

Note that in Fig. 18, the third power supply branch lines 41c which function as a mirror structure may not be provided and only the convex lens 80 may be provided.

### (Fourth embodiment)

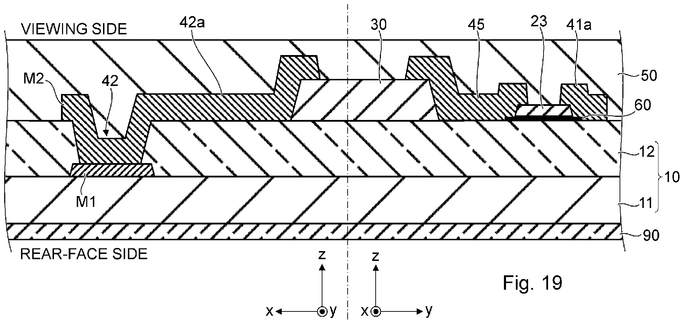

Next, a transparent display device according to a fourth embodiment will be explained with reference to Fig. 19. Fig. 19 is a schematic partial sectional view which shows an example of the transparent display device according to the fourth embodiment and which is a view corresponding to Fig. 3.

As shown in Fig. 19, in the transparent display device according to the present embodiment, a light control layer 90 is formed more toward the rear-face side than the light-shielding film 60. Specifically, the light control layer 90 is formed on the lower surface of the transparent substrate 10 in the transparent display device shown in Fig. 3.

The light control layer 90 enables internal transmittance of visible light to be dynamically adjusted. Providing the light control layer 90 enables light emitted from the LED elements 21 to 23 to the viewing side and reflected to the rear-face side to be dynamically prevented from leaking to the rear-face side. As the light control layer 90, for example, a guest-host liquid crystal, a polymer-dispersed liquid crystal, an electroactive anisotropic particle, or an electrochromic material can be used.

For example, the light control layer 90 is transparent when the LED elements 21 to 23 are not emitting light (in other words, when the LED elements 21 to 23 are not displaying an image) and the internal transmittance of visible light in the light control layer 90 is only reduced when the LED elements 21 to 23 are emitting light (in other words, when the LED elements 21 to 23 are displaying an image). According to such a configuration, light emitted from the LED elements 21 to 23 to the viewing side and reflected to the rear-face side can be prevented from leaking to the rear-face side without reducing the internal transmittance of visible light of the transparent substrate 10. Since the internal transmittance of visible light of the transparent substrate 10 is high, visibility of the rear-face side when an image is not displayed increases.

The configuration is otherwise similar to that of the transparent display device according to the first embodiment.

Note that a similar effect can be produced even when a light control layer is formed on the upper surface of the protective layer 50 in the transparent display device shown in Fig. 14.

### (Fifth embodiment)

### <Configuration of laminated glass including transparent display device>

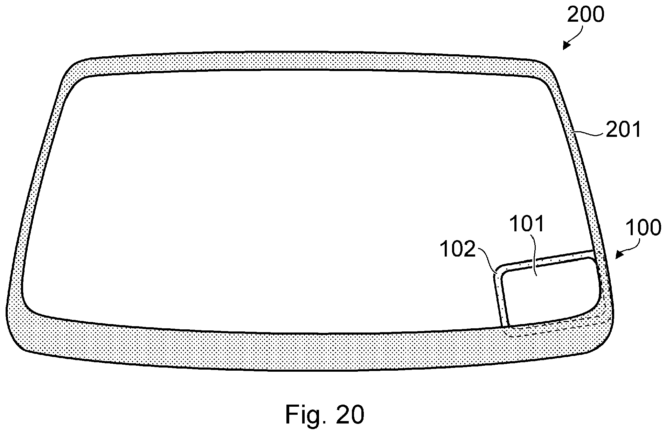

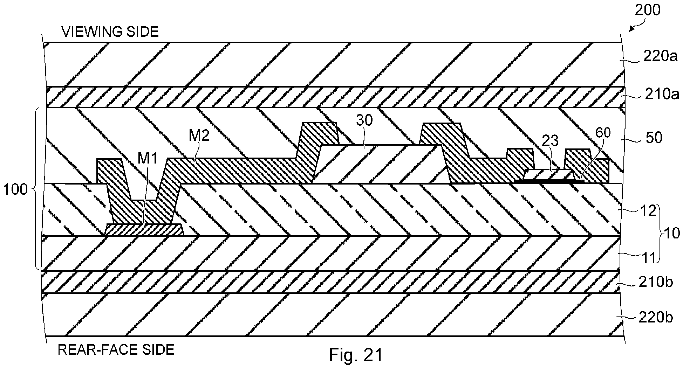

Next, a configuration of a laminated glass according to a fifth embodiment will be explained with reference to Fig. 20 and Fig. 21. Fig. 20 is a schematic plan view showing an example of the laminated glass according to the fifth embodiment. Fig. 21 is a schematic sectional view showing an example of the laminated glass according to the fifth embodiment. Although a laminated glass 200 shown in Fig. 20 and Fig. 21 is used in a windshield among window glasses for a vehicle, the laminated glass 200 is not particularly limited to a windshield.

First, a planar configuration of the laminated glass 200 will be explained with reference to Fig. 20.

As shown in Fig. 20, the laminated glass 200 is provided with, for example, a black shielding unit 201 on an entire peripheral edge thereof. The shielding unit 201 shields sunlight and protects an adhesive for assembling the laminated glass 200 to a vehicle from ultraviolet light. In addition, due to the shielding unit 201, the adhesive is no longer visually recognizable from outside.

As shown in Fig. 20, in addition to the display region 101 shown in Fig. 1, a transparent display device 100 includes a non-display region 102 provided around the display region. Since the display region 101 is a region which is constituted of a large number of pixels and in which images are to be displayed as described in the first embodiment, a detailed description thereof will be omitted at this point.

Note that although Fig. 20 is a plan view, the non-display region 102 and the shielding unit 201 are displayed by dots in order to facilitate understanding.

The non-display region 102 is a region which does not include pixels and in which images are not displayed. Wide wirings connected to the power supply line 41, the ground line 42, the row data line 43, and the column data line 44 shown in Fig. 1 are provided in a closely packed manner in the non-display region 102. A width of the wirings in the non-display region 102 is, for example, 100 to 10,000 µm and, preferably, 100 to 5,000 µm. Intervals between the wirings are, for example, 3 to 5,000 µm and, preferably, 50 to 1,500 µm.

Therefore, compared to the display region 101 being transparent, the non-display region 102 is opaque and is visually recognizable from inside a vehicle. When the non-display region 102 is visually recognizable, designability of the laminated glass 200 declines. In consideration thereof, in the laminated glass 200 according to the fifth embodiment, at least a part of the non-display region 102 of the transparent display device 100 is provided in the shielding unit 201. The non-display region 102 provided in the shielding unit 201 is hidden by the shielding unit 201 and is not visually recognizable. Therefore, designability of the laminated glass 200 improves as compared to a case where an entirety of the non-display region 102 is visually recognizable.

Next, a sectional configuration of the laminated glass 200 will be explained with reference to Fig. 21. Fig. 21 is a sectional view in the display region 101 of the transparent display device 100.

As shown in Fig. 21, the laminated glass 200 according to the fifth embodiment is constructed by bonding together a pair of glass plates 220a and 220b with an interlayer interposed therebetween. In addition, the laminated glass 200 includes the transparent display device 100 according to the first embodiment between the pair of glass plates 220a and 220b with interlayers 210a and 210b interposed therebetween. For example, the interlayers 210a and 210b are constituted of polyvinyl butyral (PVB). A refractive index of the interlayer 210a in contact with the protective layer 50 is preferably higher than the refractive index of the protective layer 50 since light can be prevented from being confined in the protective layer 50 and the protective layer 50 becomes less visually recognizable from the rear.

In addition, as shown in Fig. 21, in the laminated glass 200 according to the present embodiment, the interlayer 210b and the glass plate 220b are positioned more toward the rear-face side than the light-shielding film 60. In consideration thereof, in order to prevent light emitted from the LED elements 21 to 23 to the viewing side and reflected to the rear-face side from leaking to the rear-face side, internal transmittance of visible light of at least any of the interlayer 210b and the glass plate 220b may be set to, for example, 90% or lower. From such a perspective, the internal transmittance of visible light of at least any of the interlayer 210b and the glass plate 220b is preferably 70% or lower and more preferably 50% or lower.

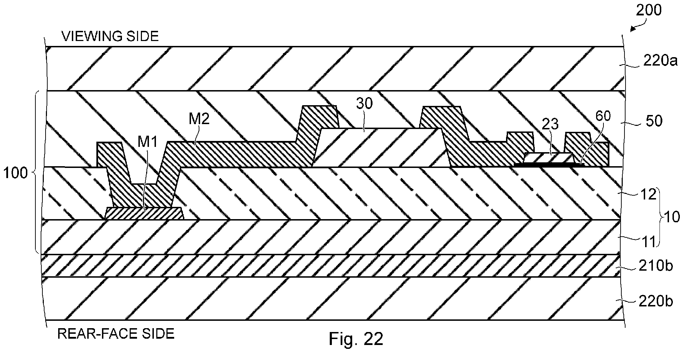

Fig. 22 is a schematic sectional view showing another example of the laminated glass according to the fifth embodiment. In the laminated glass 200 shown in Fig. 22, the protective layer 50 in the transparent display device 100 is constituted of, for example, polyvinyl butyral (PVB) and also functions as an interlayer. Therefore, in the laminated glass 200 shown in Fig. 22, the interlayer 210a formed on the protective layer 50 in Fig. 21 can be omitted. In this case, a refractive index of the glass plate 220a in contact with the protective layer 50 is preferably higher than the refractive index of the protective layer 50 since light can be prevented from being confined in the protective layer 50 and the protective layer 50 becomes less visually recognizable from the rear.

The present invention is not limited to the embodiments described above and can be appropriately modified without deviating from the scope and spirit of the disclosure.

The present application claims priority on the basis of Japanese Patent Application No. 2020-202483 filed on December 7, 2020, the entire contents of which are incorporated herein by reference.

### Reference Signs List

10 TRANSPARENT SUBSTRATE
11 MAIN SUBSTRATE
12 ADHESIVE LAYER
20 LIGHT-EMITTING UNIT
21 to 23 LED ELEMENT
30 IC CHIP
40 WIRING
41 POWER SUPPLY LINE
41a FIRST POWER SUPPLY BRANCH LINE
41b SECOND POWER SUPPLY BRANCH LINE
41c THIRD POWER SUPPLY BRANCH LINE
42 GROUND LINE
42a GROUND BRANCH LINE
43 ROW DATA LINE
43a ROW DATA BRANCH LINE
44 COLUMN DATA LINE
44a COLUMN DATA BRANCH LINE
45 DRIVE LINE
50 PROTECTIVE LAYER
60 LIGHT-SHIELDING FILM
70 ANTIREFLECTIVE FILM
80 CONVEX LENS
90 LIGHT CONTROL LAYER
100 TRANSPARENT DISPLAY DEVICE
101 DISPLAY REGION
102 NON-DISPLAY REGION
200 LAMINATED GLASS
201 SHIELDING UNIT
210a, 210b INTERLAYER
220a, 220b GLASS PLATE
FR1, FR2 PHOTORESIST
M1 FIRST METAL LAYER
M2 SECOND METAL LAYER
PIX PIXEL

## Claims

1. A transparent display device, comprising:
a transparent substrate; and
a light-emitting diode element arranged for each pixel on the transparent substrate,
a rear-face side of the transparent display device being visually recognizable from a viewing side, wherein
the light-emitting diode element is a semiconductor chip with an area of 10,000 µm² or less, and
a main surface on the rear-face side in the light-emitting diode element is covered by a light-shielding film.

2. The transparent display device according to claim 1, wherein
the light-shielding film is configured to cover an entire main surface on the rear-face side of the light-emitting diode element and formed so as to protrude from the main surface.

3. The transparent display device according to claim 1 or 2, wherein
internal transmittance of visible light in a transparent member positioned more toward the rear-face side than the light-shielding film is 90% or less.

4. The transparent display device according to claim 3, wherein
the transparent substrate is the transparent member.

5. The transparent display device according to claim 4, further comprising:
a protective layer configured to cover the light-emitting diode element on the transparent substrate; and
an antireflective film formed on the protective layer.

6. The transparent display device according to claim 3, further comprising:
a protective layer configured to cover the light-emitting diode element on the transparent substrate, wherein
the protective layer is the transparent member.

7. The transparent display device according to claim 6, further comprising:
an antireflective film formed on a main surface on the viewing side in the transparent substrate.

8. The transparent display device according to claim 1 or 2, further comprising:
more toward the rear-face side than the light-shielding film, a light control layer configured to be capable of dynamically adjusting internal transmittance of visible light.

9. The transparent display device according to any one of claims 1 to 8, further comprising:
a mirror structure formed so as to surround the light-emitting diode element.

10. The transparent display device according to any one of claims 1 to 9, wherein
an entire main surface on the viewing side in the light-emitting diode element is covered by a lens.

11. A laminated glass, comprising:
a pair of glass plates; and
a transparent display device provided between the pair of glass plates, wherein
the transparent display device includes:
a transparent substrate; and
a light-emitting diode element arranged for each pixel on the transparent substrate,
a rear-face side of the transparent display device being visually recognizable from a viewing side,
the light-emitting diode element is a semiconductor chip with an area of 10,000 µm² or less, and
a main surface on the rear-face side in the light-emitting diode element is covered by a light-shielding film.

12. A manufacturing method of a transparent display device of which a rear-face side is visually recognizable from a viewing side, the manufacturing method comprising:
arranging a light-emitting diode element being a semiconductor chip having an area of 10,000 µm² or less for each pixel on a transparent substrate; and
covering a main surface on the rear-face side in the light-emitting diode element with a light-shielding film.
